# EUROPEAN PATENT APPLICATION

(11) **EP 4 847 582 A1**
(43) Date of publication of application: **02.12.2026**
(21) Application number: 25745018.9
(22) Date of filing: 10.01.2025
(51) Int. Cl.: C09K 11/66, C09K 11/62, C09K 11/64, C09K 11/77, C09K 11/79, C09K 11/80, G01N 21/01, G01N 21/359, G02B 5/20, H10H 20/851

(54) **NEAR-INFRARED PHOSPHOR, NEAR-INFRARED LIGHT-EMITTING DEVICE, SPECTROSCOPIC DEVICE, AND SENSING DEVICE**

(30) Priority: 23.01.2024 JP 2024007866
(71) Applicant: Panasonic Intellectual Property Management Co., Ltd., Kadoma-shi, Osaka 571-0057 (JP)
(72) Inventor: IWATA, Koki, Kadoma-shi, Osaka 571-0057 (JP); NITTA, Mitsuru, Kadoma-shi, Osaka 571-0057 (JP)
(74) Representative: Müller-Boré & Partner Patentanwälte PartG mbB
(86) International application number: PCT/JP2025/000618
(87) International publication number: WO 2025/158935

(57) **Abstract**

Provided is a near-infrared phosphor, obtained by doping, with Cr ions, an inorganic compound having the same orthorhombic crystal structure as that of Mg₂GeO₄ and represented by general formula (1).

(MAₚMC_{q})_{z}(MB₂ᵣ)_{1-z}(MD)ₛO₄ ··· (1)

MA is one or more elements selected from Group 1 elements and Group 11 elements, MB is one or more elements selected from Group 2 elements and Group 12 elements, MC is one or more elements selected from Group 3 elements and Group 13 elements, MD is one or more elements selected from Group 4 elements and Group 14 elements, and p, q, r, s, and z satisfy 0.8 ≤ p ≤ 1.2, 0.8 ≤ q ≤ 1.2, 0.8 ≤ r ≤ 1.2, 0.8 ≤ s ≤ 1.2, and 0.01 ≤ z ≤ 0.49. A near-infrared light-emitting device includes the near-infrared phosphor, and a spectroscopic device and a sensing device include the near-infrared light-emitting device.

## Description

### TECHNICAL FIELD

The present disclosure relates to a near-infrared phosphor, a near-infrared light-emitting device, a spectroscopic device, and a sensing device.

### BACKGROUND ART

Near-infrared light has a property of easily penetrating the living body, and thus it is useful for obtaining information inside the living body, and treating lesions inside the living body. Near-infrared light has a property of penetrating organic substances, and thus it is also advantageous when inspecting contents or a foreign substance in a container made from an organic substance, in an unopened state. Thus, a near-infrared light-emitting device that emits near-infrared light is expected to be applied to medical lighting and inspection equipment lighting.

The near-infrared light-emitting device uses a near-infrared phosphor that is excited by excitation light emitted from a solid-state light-emitting element, and emits near-infrared light. Patent Literature 1 describes a near-infrared light-emitting material excited by blue light or red light. The near-infrared light-emitting material is represented by the chemical formula: LiMg₂M₁₋ₓGe₂O₈:x%Cr³⁺, satisfies 0.01 ≤ x ≤ 20, where M is one or two elements selected from Sc and In. The near-infrared light-emitting material has excitation peaks in wavelength ranges of 250 to 360 nm, 360 to 560 nm, and 560 to 900 nm, has an emission wavelength range of 850 to 1,400 nm, and has an emission full width at half maximum of approximately 300 nm. In addition, Patent Literature 1 discloses, in example 1, a phosphor represented by the chemical formula: LiMg₂Sc_{0.96}Cr_{0.04}Ge₂O₈, and the emission peak of the phosphor is near 1,030 nm. Note that fluorescence peaks of all phosphors illustrated in examples of Patent Literature 1 exceed 1,000 nm.

### CITATION LIST

### PATENT LITERATURE

Patent Literature 1: Chinese Unexamined Patent Application Publication 112322290

### SUMMARY OF INVENTION

A spectroscopic device using near-infrared light includes a near-infrared light-emitting device that emits near-infrared light as described above, and a sensor (detector) that detects near-infrared light transmitted through or reflected by an inspection object. An Si-based sensor or InGaAs-based sensor is used as the sensor. An Si-based sensor can detect, with high sensitivity, near-infrared light having a wavelength of 1,000 nm or less, and an InGaAs-based sensor can detect, with high sensitivity, near-infrared light having a wavelength exceeding 1,000 nm.

However, an InGaAs-based sensor is more expensive than a Si-based sensor, and the maximum measurable wavelength of a Si-based sensor is approximately 1,000 nm. Thus, when a relatively inexpensive Si-based sensor is used, it is necessary that the peak wavelength of fluorescence emitted by the near-infrared phosphor be 1,000 nm or less.

Furthermore, as a result of the present inventors preparing the near-infrared light-emitting material of Patent Literature 1 and evaluating its fluorescence properties, it was found that the near-infrared light-emitting material does not have sufficient fluorescence properties. Thus, a near-infrared phosphor having excellent fluorescence properties is needed.

The present disclosure has been made in consideration of the above issue, which is inherent in the related art. An object of the present disclosure is to provide a near-infrared phosphor capable of emitting fluorescence which is detectable with high sensitivity by a Si-based sensor, and which has excellent fluorescence properties, as well as a near-infrared light-emitting device provided with the near-infrared phosphor. An object of the present disclosure is to further provide a spectroscopic device and a sensing device, each provided with the near-infrared light-emitting device.

In response to the above issues, a near-infrared phosphor according to an aspect of the present disclosure is obtained by doping, with Cr ions, an inorganic compound having the same orthorhombic crystal structure as that of Mg₂GeO₄ and represented by general formula (1).

(MAₚMC_{q})_{z}(MB₂ᵣ)_{1-z}(MD)ₛO₄ ··· (1)

(where MA is one or more elements selected from Group 1 elements and Group 11 elements, MB is one or more elements selected from Group 2 elements and Group 12 elements, MC is one or more elements selected from Group 3 elements and Group 13 elements, MD is one or more elements selected from Group 4 elements and Group 14 elements, and p, q, r, s, and z satisfy 0.8 ≤ p ≤ 1.2, 0.8 ≤ q ≤ 1.2, 0.8 ≤ r ≤ 1.2, 0.8 ≤ s ≤ 1.2, and 0.01 ≤ z ≤ 0.49.).

A near-infrared light-emitting device according to an aspect of the present disclosure includes the near-infrared phosphor described above.

A spectroscopic device according to an aspect of the present disclosure includes the near-infrared light-emitting device described above.

A sensing device according to an aspect of the present disclosure includes the near-infrared light-emitting device described above.

### BRIEF DESCRIPTION OF DRAWINGS

[Fig. 1] Fig. 1 is a schematic diagram illustrating an example of a near-infrared light-emitting device according to the present embodiment.
[Fig. 2] Fig. 2 is a schematic diagram illustrating another example of the near-infrared light-emitting device according to the present embodiment.
[Fig. 3] Fig. 3 is a schematic diagram illustrating an example of a spectroscopic device according to the present embodiment.
[Fig. 4] Fig. 4 is a schematic diagram illustrating another example of the spectroscopic device according to the present embodiment.
[Fig. 5] Fig. 5 is a graph illustrating X-ray diffraction spectra of phosphors of example 1-1, and comparative examples 1-2 to 1-5, as well as crystal structure data of Mg₂GeO₄ and LiScGeO₄.
[Fig. 6] Fig. 6 is a graph illustrating emission spectra obtained when phosphors of example 1-1, and comparative examples 1-2, 1-3, and 1-5 are excited at a wavelength of 450 nm.

### DESCRIPTION OF EMBODIMENTS

Referring to the drawings, a description is given below of a near-infrared phosphor, a near-infrared light-emitting device, a spectroscopic device, and a sensing device according to the present embodiment. Note that dimensional ratios in the drawings are exaggerated for convenience of the description and are sometimes different from actual ratios.

As described above, Patent Literature 1 discloses a near-infrared light-emitting material represented by LiMg₂M₁₋ₓGe₂O₈:x%Cr³⁺, and specifically discloses a LiMg₂Sc_{0.96}Cr_{0.04}Ge₂O₈ phosphor. Furthermore, Non-Patent Literatures 1 and 2 disclose a Mg₂GeO₄:Cr phosphor and a LiScGeO₄:Cr phosphor, respectively, which are simple systems of the near-infrared light-emitting material of Patent Literature 1.
[Non-Patent Literature 1] Yongcheng Huo et al., "Enabling Yb3+ Luminescence with Visible Light Response in Mg2GeO4 via Energy Transfer", Inorg. Chem. 2023, 62, 35, 14402-14410
[Non-Patent Literature 2] Shihai Miao et al., "Broadband Short-Wave Infrared Light-Emitting Diodes Based on Cr3+-Doped LiScGeO4 Phosphor", ACS Appl. Mater. Interfaces 2021, 13, 30, 36011-36019

Here, the present inventors prepared LiMg₂ScGe₂O₈:1%Cr, which is the phosphor of Patent Literature 1, Mg₂GeO₄:1%Cr, which is the phosphor of Non-Patent Literature 1, and LiScGeO₄:1%Cr, which is the phosphor of Non-Patent Literature 2, and evaluated their fluorescence properties. In these phosphors, the concentration of Cr ions, which is an activator, was uniformly set to 1 mol%. Note that as a result of measuring the crystal structures of these phosphors using an X-ray diffraction method, the XRD patterns thereof were found to be approximately identical, and thus the crystal structures of these phosphors were the same. The fluorescence peak wavelength, internal quantum efficiency (IQE), absorbance, and external quantum efficiency (EQE) of these phosphors were then measured.

As listed in Table 1, the phosphor of Patent Literature 1 has a fluorescence peak wavelength of approximately 1,000 nm, and when a Si-based sensor is used, further shortening of the wavelength is needed. In contrast, the phosphor of Non-Patent Literature 1 has a fluorescence peak wavelength of approximately 900 nm and can suitably be used with a Si-based sensor; however, its internal quantum efficiency, absorbance, and external quantum efficiency are worse than those of the phosphor of Patent Literature 1, and improvement of fluorescence properties is needed. In addition, the phosphor of Non-Patent Literature 2 has internal quantum efficiency, absorbance, and external quantum efficiency comparable to those of the phosphor of Patent Literature 1; however, its fluorescence peak wavelength is approximately 1,100 nm. Note that the fluorescence properties of the phosphors of Patent Literature 1 and Non-Patent Literature 2 cannot be considered favorable, and further improvement is needed.

**[Table 1]**

| | Non-Patent Literature 1 | Patent Literature 1 | Non-Patent Literature 2 |
|---|---|---|---|
| Composition | Mg₂GeO₄:0.3%Cr | LiMg₂ScGe₂O₈:0.3%Cr | LiScGeO₄:0.3%Cr |
| Fluorescence peak wavelength | 900nm | 1000nm | 1100nm |
| Internal quantum efficiency (IQE) | 6% | 14% | 17% |
| Light absorption rate (Abs.) | 24% | 39% | 36% |
| External quantum efficiency (EQE) | 1.40% | 5.50% | 6.10% |

A near-infrared phosphor according to the present embodiment can emit fluorescence detectable with high sensitivity even by a Si-based sensor having a maximum measurable wavelength of approximately 1,000 nm, and is a phosphor having excellent fluorescence properties.

### [Near-infrared phosphor]

A near-infrared phosphor according to the present embodiment is a phosphor that is obtained by doping, with Cr ions, an inorganic compound having the same orthorhombic crystal structure as that of the compound Mg₂GeO₄ and represented by general formula (1) below. The near-infrared phosphor according to the present embodiment is one in which part of the crystal structure represented by general formula (1) has been substituted with Cr³⁺.

(MAₚMC_{q})_{z}(MB₂ᵣ)_{1-z}(MD)ₛO₄ ··· (1)

In the formula, MA is one or more elements selected from Group 1 elements and Group 11 elements. MB is one or more elements selected from Group 2 elements and Group 12 elements. MC is one or more elements selected from Group 3 elements and Group 13 elements. MD is one or more elements selected from Group 4 elements and Group 14 elements. Furthermore, p, q, r, s, and z satisfy 0.8 ≤ p ≤ 1.2, 0.8 ≤ q ≤ 1.2, 0.8 ≤ r ≤ 1.2, 0.8 ≤ s ≤ 1.2, and 0.01 ≤ z ≤ 0.49.

The near-infrared phosphor according to the present embodiment has the same orthorhombic crystal structure as the compound Mg₂GeO₄, and is a Cr-activated phosphor having a solid solution of Mg₂GeO₄ and LiScGeO₄ as a host crystal. In addition, the near-infrared phosphor is also a Cr-activated phosphor having an intermediate composition between Mg₂GeO₄ and LiScMg₂Ge₂O₈ as a host crystal.

In general formula (1), MA is a monovalent element and is one or more elements selected from Group 1 elements and Group 11 elements. Since Group 1 elements and Group 11 elements are both monovalent elements, and have similar ionic radii within the same period, these elements can be easily substituted for each other.

Note that MA may be an alkali metal and, specifically, may be at least one selected from the group consisting of lithium (Li), sodium (Na), potassium (K), rubidium (Rb), and cesium (Cs). MA is preferably at least one of lithium or sodium, and more preferably lithium. When MA is one of these elements, it becomes possible to enhance the fluorescence properties of wavelength-converted light emitted from the near-infrared phosphor, particularly the internal quantum efficiency, external quantum efficiency, and light absorption rate.

In general formula (1), MB is a divalent element and is one or more elements selected from Group 2 elements and Group 12 elements. Since Group 2 elements and Group 12 elements are both divalent elements, and have similar ionic radii within the same period, these elements can be easily substituted for each other.

Note that MB may be at least one of an alkaline earth metal or zinc and, specifically, may be at least one selected from the group consisting of beryllium (Be), magnesium (Mg), calcium (Ca), strontium (Sr), barium (Ba), radium (Ra), and zinc (Zn). MB is preferably magnesium. When MB is one of these elements, it becomes possible to enhance the fluorescence properties of wavelength-converted light emitted from the near-infrared phosphor, particularly the internal quantum efficiency, external quantum efficiency, and light absorption rate.

In general formula (1), MC is a trivalent element and is one or more elements selected from Group 3 elements and Group 13 elements. Since group 3 elements and Group 13 elements are both trivalent elements, and have similar ionic radii within the same period, these elements can be easily substituted for each other.

Note that MC may be at least one selected from the group consisting of scandium (Sc), yttrium (Y), lutetium (Lu), aluminum (Al), gallium (Ga), and indium (In). MC is preferably scandium, aluminum, or gallium. When MC is one of these elements, it becomes possible to enhance the fluorescence properties of wavelength-converted light emitted from the near-infrared phosphor, particularly the internal quantum efficiency, external quantum efficiency, and light absorption rate.

In general formula (1), MD is a tetravalent element and is one or more elements selected from Group 4 elements and Group 14 elements. Since Group 4 elements and Group 14 elements are both tetravalent elements, and have similar ionic radii within the same period, these elements can be easily substituted for each other.

Note that MD may be at least one selected from the group consisting of titanium (Ti), zirconium (Zr), hafnium (Hf), silicon (Si), germanium (Ge), tin (Sn), and lead (Pb). MD is preferably silicon or germanium. When MD is one of these elements, it becomes possible to enhance the fluorescence properties of wavelength-converted light emitted from the near-infrared phosphor, particularly the internal quantum efficiency, external quantum efficiency, and light absorption rate.

In general formula (1), p, q, r, and s satisfy 0.8 ≤ p ≤ 1.2, 0.8 ≤ q ≤ 1.2, 0.8 ≤ r ≤ 1.2, and 0.8 ≤ s ≤ 1.2. However, it is more preferable that p, q, r, and s satisfy 0.9 ≤ p ≤ 1.1, 0.9 ≤ q ≤ 1.1, 0.9 ≤ r ≤ 1.1, and 0.9 ≤ s ≤ 1.1.

In general formula (1), z satisfies 0.01 ≤ z ≤ 0.49. Since the z value in general formula (1) is within this range, the peak wavelength of fluorescence emitted from the near-infrared phosphor becomes 1,000 nm or less, thereby enabling detection with high sensitivity even by silicon-based sensors such as CMOS using silicon. Furthermore, since the z value is within this range, it becomes possible to enhance the fluorescence properties, particularly the internal quantum efficiency, external quantum efficiency, and light absorption rate.

Here, when z = 0 in general formula (1), general formula (1) encompasses the phosphor described in Non-Patent Literature 1. However, as described above, the Mg₂GeO₄:Cr phosphor described in Non-Patent Literature 1 has a fluorescence peak wavelength of approximately 900 nm and can suitably be used with a Si-based sensor, but its fluorescence properties are insufficient. In addition, when z = 0.5, the formula encompasses the phosphor described in Patent Literature 1. However, the LiMg₂M₁₋ₓGe₂O₈:x%Cr³⁺ phosphor described in Patent Literature 1 has a fluorescence peak wavelength of approximately 1,000 nm, and when using a Si-based sensor, further shortening of the wavelength is needed. Furthermore, the fluorescence properties of the phosphor of Patent Literature 1 cannot be said to be favorable.

However, the near-infrared phosphor according to the present embodiment does not merely have intermediate values between the fluorescence properties of the Mg₂GeO₄:Cr phosphor described in Non-Patent Literature 1, and those of the LiMg₂M₁₋ₓGe₂O₈:x%Cr³⁺ phosphor described in Patent Literature 1, but has higher fluorescence properties than both of these phosphors. Thus, by combining the near-infrared phosphor according to the present embodiment with an excitation light source, such as a solid-state light-emitting element, high-efficiency near-infrared illumination can be provided. Furthermore, with the enhancement of the fluorescence properties of the near-infrared phosphor, high-output near-infrared illumination can be provided even when the output of the excitation light source is reduced.

Note that in general formula (1), z preferably satisfies 0.05 ≤ z ≤ 0.45, and more preferably satisfies 0.1 ≤ z ≤ 0.4. Since the z value in general formula (1) is within these ranges, the fluorescence properties of fluorescence emitted from the near-infrared phosphor can be further enhanced. Furthermore, since the z value is within the above ranges, the emission peak wavelength of near-infrared light emitted from the near-infrared phosphor can be shifted to even shorter wavelengths.

The near-infrared phosphor according to the present embodiment is a phosphor that absorbs excitation light emitted by a solid-state light-emitting element, and converts the excitation light into wavelength-converted light including near-infrared light. Since the near-infrared phosphor includes Cr³⁺ ions as an activator, it can absorb visible light, particularly blue light or red light, and emit near-infrared light components. Thus, excitation light applied to the near-infrared phosphor is preferably blue light having an intensity maximum within a wavelength range of 430 nm or more and 480 nm or less. With this configuration, the near-infrared phosphor can be excited with high efficiency, and thus a high-efficiency near-infrared light-emitting device can be obtained. The excitation light applied to the near-infrared phosphor may also be red light having an intensity maximum within a wavelength range of 600 nm or more and 700 nm or less. With this configuration, since the near-infrared phosphor is excited by relatively low-energy red light, a near-infrared light-emitting device with little heat generation due to Stokes losses in the phosphor can be obtained. Note that the near-infrared phosphor preferably emits fluorescence when irradiated with excitation light at a wavelength of 450 nm.

In the near-infrared phosphor according to the present embodiment, the amount of chromium ions added as an activator is not particularly limited. However, the concentration of chromium in the near-infrared phosphor preferably satisfies 0.03 mol% or more and 10.0 mol% or less, and more preferably satisfies 0.1 mol% or more and 3.0 mol% or less, relative to the total molar amount of metal elements. As the chromium concentration in the near-infrared phosphor increases, the light absorption rate tends to improve, and as the chromium concentration decreases, the internal quantum efficiency tends to improve.

The spectral distribution of fluorescence emitted by the near-infrared phosphor according to the present embodiment preferably has a maximum fluorescence intensity value within a wavelength range of 800 nm or more and 1,600 nm or less. This enables the phosphor to be used for moisture content measurement in food, food quality evaluation of fresh fish, meat, and the like, and resin component analysis for the purpose of plastic sorting. The spectral distribution of fluorescence emitted by the near-infrared phosphor according to the present embodiment preferably has a maximum fluorescence intensity value within a wavelength range of 800 nm or more and 1,000 nm or less, and more preferably within a wavelength range of 900 nm or more and 1,000 nm or less. This enables detection with high sensitivity even by relatively inexpensive Si-based sensors.

In the fluorescence emitted by the near-infrared phosphor according to the present embodiment, the full width at half maximum of the spectrum having the maximum fluorescence intensity value preferably exceeds 100 nm. This makes it possible to obtain near-infrared light components having a spectral distribution over a wide wavelength range with only one type of near-infrared phosphor, without using several types of near-infrared phosphors. Note that the full width at half maximum of the spectrum may be 140 nm or more, 160 nm or more, 180 nm or more, or 200 nm or more. The full width at half maximum of the spectrum may also be 340 nm or less, 320 nm or less, 300 nm or less, or 280 nm or less.

The shape of the near-infrared phosphor according to the present embodiment is not particularly limited. However, the near-infrared phosphor may be either a powder phosphor or a fluorescent ceramic. These types of near-infrared phosphors are easy to apply as a wavelength converter. The powder phosphor is suitable for easily obtaining a wavelength converter because it can be made into a wavelength converter using a simple method of mixing with a transparent resin and curing. In contrast, the fluorescent ceramic is a near-infrared phosphor obtained by sintering a powder phosphor. The fluorescent ceramic is not only excellent in thermal conductivity but also has a high light absorption rate for excitation light, and thus is suitable as a wavelength converter.

As described above, the near-infrared phosphor according to the present embodiment is a phosphor that is obtained by doping, with Cr ions, an inorganic compound having the same orthorhombic crystal structure as that of Mg₂GeO₄ and represented by general formula (1) below.

(MAₚMC_{q})_{z}(MB₂ᵣ)_{1-z}(MD)ₛO₄ ··· (1)

In the formula, MA is one or more elements selected from Group 1 elements and Group 11 elements. MB is one or more elements selected from Group 2 elements and Group 12 elements. MC is one or more elements selected from Group 3 elements and Group 13 elements. MD is one or more elements selected from Group 4 elements and Group 14 elements. Here, p, q, r, s, and z satisfy 0.8 ≤ p ≤ 1.2, 0.8 ≤ q ≤ 1.2, 0.8 ≤ r ≤ 1.2, 0.8 ≤ s ≤ 1.2, and 0.01 ≤ z ≤ 0.49.

By having the above composition, the near-infrared phosphor according to the present embodiment can emit fluorescence detectable with high sensitivity, even by a relatively inexpensive Si-based sensor, and can also have favorable fluorescence properties. Thus, the near-infrared phosphor can be applied to a wide range of quality analyses, such as moisture content, and food quality evaluation of fresh fish, meat, and the like. Since the near-infrared phosphor according to the present embodiment can have a fluorescence peak particularly within a wavelength range of 900 to 1,000 nm, it is possible to obtain a broad near-infrared spectrum by combining it with another near-infrared phosphor. Consequently, it becomes possible to produce illumination for near-infrared sensing with higher accuracy.

Note that the near-infrared phosphor according to the present embodiment is a phosphor obtained by doping, with Cr ions, an inorganic compound represented by general formula (1) above, but it can also be represented as follows.

The near-infrared phosphor according to the present embodiment is a phosphor that is obtained by doping, with Cr ions, an inorganic compound having the same orthorhombic crystal structure as that of Mg₂GeO₄ and represented by general formula (2) below.

(1-z)MB₂MD₁O₄·zMA₁MC₁MD₁O₄ ··· (2)

In the formula, MA is one or more elements selected from Group 1 elements and Group 11 elements. MB is one or more elements selected from Group 2 elements and Group 12 elements. MC is one or more elements selected from Group 3 elements and Group 13 elements. MD is one or more elements selected from Group 4 elements and Group 14 elements. Here, z satisfies 0.01 ≤ z ≤ 0.49.

Since the near-infrared phosphor according to the present embodiment has as its host crystal an inorganic compound including a solid solution of MB₂MD₁O₄ and MA₁MC₁MD₁O₄, the inorganic compound can also be represented as general formula (2).

### [Near-infrared light-emitting device]

Next, a near-infrared light-emitting device according to the present embodiment will be described. A near-infrared light-emitting device 100 according to the present embodiment includes the near-infrared phosphor described above. Because the near-infrared phosphor according to the present embodiment has favorable fluorescence properties, the near-infrared light-emitting device 100 can output high-output near-infrared light components suitable for near-infrared spectroscopy.

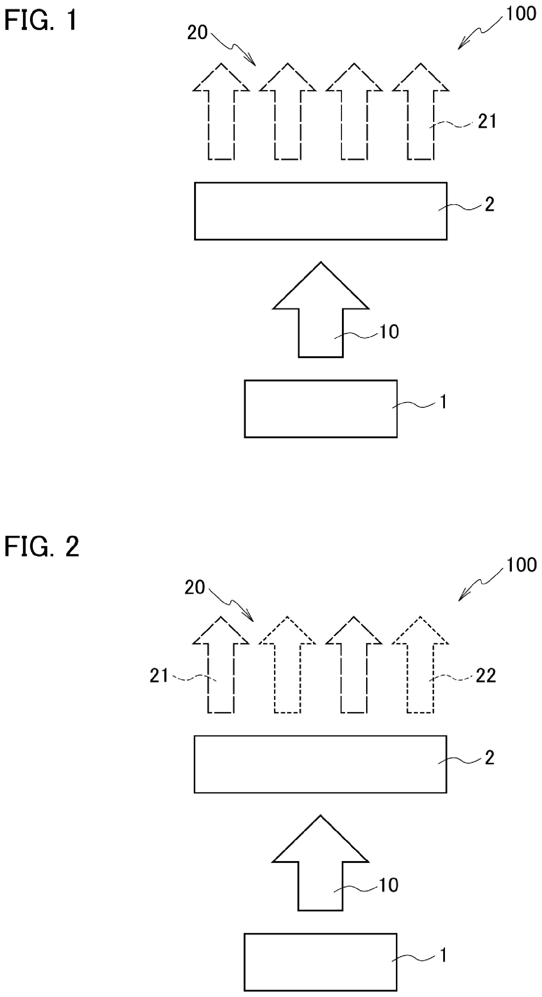

Fig. 1 schematically illustrates an example of the near-infrared light-emitting device 100 according to the present embodiment. As illustrated in Fig. 1, the near-infrared light-emitting device 100 includes a solid-state light-emitting element 1 and a wavelength converter 2. The wavelength converter 2 includes the near-infrared phosphor described above. The near-infrared light-emitting device 100 is configured to emit output light 20 including near-infrared light 21 emitted by the near-infrared phosphor.

The solid-state light-emitting element 1 is configured to emit primary light (excitation light) 10. The output light 20 may include the primary light 10. The primary light 10 is preferably blue light having an intensity maximum within a blue wavelength range of 435 nm or more and less than 480 nm, particularly 440 nm or more and less than 470 nm. When the near-infrared phosphor is excited by the primary light 10, since the near-infrared phosphor is excited by blue light of a relatively short wavelength, the near-infrared light-emitting device 100 is suitable to be used in combination with visible phosphors of green to yellow to orange to red colors, as necessary.

The solid-state light-emitting element 1 is an element that converts electricity into light, and when it is driven by a supply of electric energy, it converts the supplied electrical energy into light energy. It then emits the converted light energy as primary light 10 from a light extraction surface. Note that representative examples of the solid-state light-emitting element 1 include light-emitting diodes (LEDs) and laser diodes (LDs).

The wavelength converter 2 includes the near-infrared phosphor described above. The wavelength converter 2 may be, for example, a resin molded body where particles of the near-infrared phosphor are dispersed in a resin, or a fluorescent ceramic obtained by compressing and sintering powder of the near-infrared phosphor.

The wavelength converter 2 may include a fluorescent ceramic as a main component. The fluorescent ceramic not only improves the thermal conductivity of the wavelength converter 2 but also increases the light absorption rate of excitation light. Thus, by using the fluorescent ceramic, the near-infrared light-emitting device 100 becomes advantageous in terms of heat dissipation design and achieving high power output, particularly achieving high power output of the near-infrared light components. The wavelength converter 2 including the fluorescent ceramic as a main component means that the wavelength converter 2 includes 75 wt% or more of the fluorescent ceramic. The wavelength converter 2 may include 90 wt% or more of the fluorescent ceramic.

The fluorescent ceramic may include the near-infrared phosphor as a main component. The fluorescent ceramic including the near-infrared phosphor as a main component means that the fluorescent ceramic includes 75 wt% or more of the near-infrared phosphor. The fluorescent ceramic may include the near-infrared phosphor in an amount of 90 wt% or more, or 100 wt%. This provides not only excellent thermal conductivity but also a high light absorption rate for excitation light. This is therefore advantageous for heat dissipation design and achieving high power output, particularly high power output of the near-infrared light components.

The near-infrared phosphor is preferably excited by the primary light 10 emitted by the solid-state light-emitting element 1. In this way, the near-infrared light-emitting device 100 takes a form where the solid-state light-emitting element 1 is utilized to excite the near-infrared phosphor with the primary light 10 emitted therefrom, which is advantageous for all-solid-state implementation.

The near-infrared light-emitting device 100 emits output light 20 including near-infrared light 21 emitted by the near-infrared phosphor, and the output light 20 may have spectral intensity across at least the entire wavelength range of 800 nm or more and 1,300 nm or less. The near-infrared light-emitting device 100, which emits the output light 20 described above, is suitable for detection or analysis of characteristic absorption bands of stretching vibrations of N-H, C-H, and O-H using a spectroscopic method, food quality evaluation of fresh fish, meat, and the like, and resin component analysis for the purpose of plastic sorting. Note that the output light 20 may have spectral intensity across at least the entire wavelength range of 700 nm or more and 1,000 nm or less. The near-infrared light-emitting device 100, which emits the output light 20 described above, is suitable for detection or analysis of characteristic absorption bands of stretching vibrations of N-H, C-H, and O-H using the spectroscopic method. The output light 20 may have spectral intensity across at least the entire wavelength range of 1,100 nm or more and 1,400 nm or less. The spectral distribution described above is suitable for food quality evaluation of fresh fish, meat, and the like, and resin component analysis for the purpose of plastic sorting.

The near-infrared light-emitting device 100 emits output light 20 including near-infrared light 21 emitted by the near-infrared phosphor, and the output light 20 may have a spectral peak within a wavelength range of 800 nm or more and 1,600 nm or less, particularly 800 nm or more and 860 nm or less. The output light 20 has a spectral peak in the near-infrared wavelength region, which is close in form to that of a halogen lamp. This makes it relatively easy to use the components and associated software of conventional spectroscopic devices that use halogen lamps. Thus, spectroscopic devices can be manufactured industrially without major design changes. In addition, it has recently been found that briefly irradiating harvested fruits and vegetables with near-infrared light near a wavelength of 850 nm can control subsequent freshness deterioration and decay, and can improve fruit quality such as maintaining vitamin C, controlling softening, and maintaining gloss. Thus, the near-infrared light-emitting device 100 according to the present embodiment is advantageous for maintaining the freshness of fruits and vegetables as described above.

As illustrated in Fig. 2, the near-infrared light-emitting device 100 may further include a visible phosphor that emits visible fluorescence 22. The near-infrared light-emitting device 100 can emit output light 20 including visible fluorescence 22. The visible fluorescence 22 may have a maximum fluorescence intensity value within a wavelength range of visible light. For example, the visible fluorescence 22 may have a maximum fluorescence intensity value within a wavelength range of 490 nm or more and less than 780 nm. The visible phosphor may be included in the same wavelength converter as the near-infrared phosphor. The visible phosphor may be included in a wavelength converter different from that including the near-infrared phosphor. For example, the near-infrared light-emitting device 100 may include a first wavelength converter and a second wavelength converter, where the first wavelength converter may include the visible phosphor, and the second wavelength converter may include the near-infrared phosphor.

The visible phosphor may be excited by the primary light 10 emitted by the solid-state light-emitting element 1. When the visible phosphor is excited by the primary light 10 emitted by the solid-state light-emitting element 1, the near-infrared light-emitting device 100 becomes advantageous for all-solid-state implementation and size reduction. The primary light 10 is preferably blue light having a maximum fluorescence intensity value within a blue wavelength range of 435 nm or more and less than 480 nm.

The near-infrared phosphor and the visible phosphor are preferably excited by only one type of solid-state light-emitting element 1. This is also advantageous for simplifying a lighting circuit. Note that it is more preferable to excite these phosphors with blue light of a relatively short wavelength, as this increases options for visible phosphors and enables adjustment of light from green to yellow to orange to red.

The visible phosphor may be at least one phosphor selected from the group consisting of: a green phosphor that emits light having a maximum fluorescence intensity value within a wavelength range of 490 nm or more and less than 570 nm; a yellow phosphor that emits light having a maximum fluorescence intensity value within a wavelength range of 570 nm or more and less than 585 nm; an orange phosphor that emits light having a maximum fluorescence intensity value within a wavelength range of 585 nm or more and less than 620 nm; and a red phosphor that emits light having a maximum fluorescence intensity value within a wavelength range of 620 nm or more and less than 780 nm. This enables adjustment of the spectral distribution of visible fluorescence components. Therefore, the visible fluorescence components of the output light 20 emitted from the near-infrared light-emitting device 100 can be adjusted according to intended application.

The visible phosphor may be at least one phosphor selected from the group consisting of a Ce³⁺-activated garnet phosphor, a Eu²⁺-activated alkaline earth metal nitridosilicate, and a Eu²⁺-activated alkaline earth metal nitridoaluminosilicate. The visible phosphor is a phosphor having a high practical track record for LED lighting. Therefore, the visible phosphor is not only easy to procure but also reliable and easy to handle, providing the near-infrared light-emitting device 100 with the visible phosphor.

Examples of Ce³⁺-activated garnet phosphors include phosphors represented by the general formula RE₃Al₂(AlO₄)₃:Ce³⁺, Ca₃Sc₂(SiO₄)₃:Ce³⁺, Y₃Ga₂(AlO₄)₃:Ce³⁺, and solid solutions thereof. In the above general formula, RE represents a rare earth element and is at least one rare earth element selected from, for example, the group consisting of Sc, Y, La, Tb, Gd, and Lu. Specific examples of phosphors represented by the general formula RE₃Al₂(AlO₄)₃:Ce³⁺ include Lu₃Al₂(AlO₄)₃:Ce³⁺, Y₃Al₂(AlO₄)₃:Ce³⁺ (YAG), and (Y,Gd)₃Al₂(AlO₄)₃:Ce³⁺.

Examples of Eu²⁺-activated alkaline earth metal nitridosilicates include Sr₂Si₅N₈:Eu²⁺, Ca₂Si₅N₈:Eu²⁺, and solid solutions thereof.

Examples of Eu²⁺-activated alkaline earth metal nitridoaluminosilicates include phosphors represented by the general formula MAlSiN₃:Eu²⁺. In the above general formula, M represents magnesium or an alkaline earth metal and is at least one metal element selected from, for example, the group consisting of Mg, Ca, Sr, and Ba. Specific examples of Eu²⁺-activated alkaline earth metal nitridoaluminosilicates include CaAlSiN₃:Eu²⁺ (CASN), SrAlSiN₃:Eu²⁺, (Sr,Ca)AlSiN₃:Eu²⁺ (SCASN), and solid solutions thereof.

Among these, the visible phosphor preferably includes at least one phosphor selected from the group consisting of YAG, CASN, and SCASN.

The near-infrared light-emitting device 100 according to the present embodiment can be widely used for non-destructive inspection using the spectroscopic method, particularly for quality evaluation of fruits and vegetables, and quality evaluation of fresh fish, meat, and processed foods. For example, oleic acid, which contributes to the meat quality of Wagyu beef, has an absorption peak near a wavelength of 930 nm; therefore, using this wavelength makes it possible to visualize the distribution of oleic acid in Wagyu beef. Lipids in tuna also have an absorption peak near a wavelength of 930 nm; therefore, using this wavelength makes it possible to measure the lipid content in tuna. In addition, using the near-infrared light-emitting device 100 makes it possible to measure the moisture content in food.

As described above, the near-infrared light-emitting device 100 according to the present embodiment includes the near-infrared phosphor described above. Therefore, the near-infrared light-emitting device 100 can be widely used, for example, as a light source for spectroscopic devices that employ the spectroscopic method.

### [Spectroscopic device]

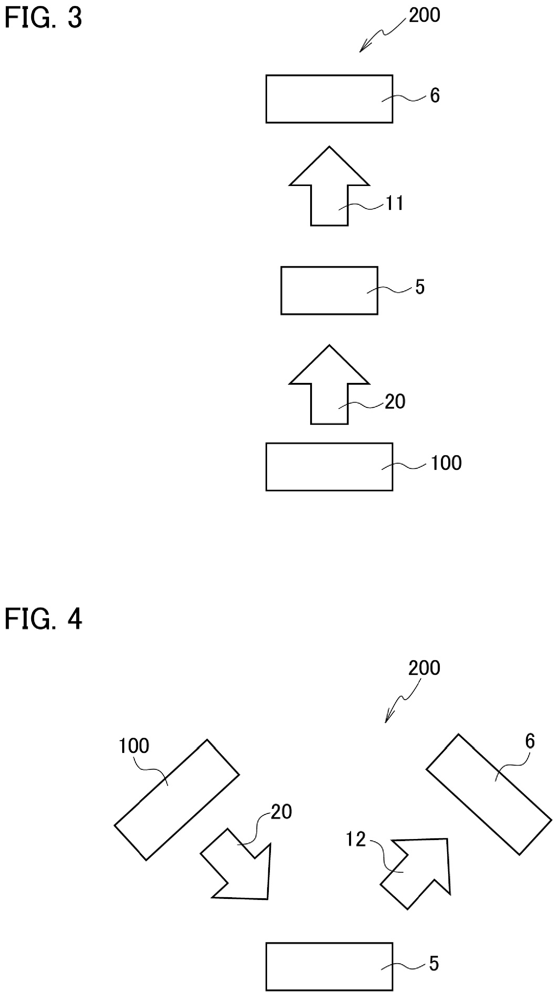

Next, a spectroscopic device 200 according to the present embodiment will be described with reference to Figs. 3 and 4. The spectroscopic device 200 is, for example, a near-infrared spectroscopic device. Fig. 3 schematically illustrates an example of the spectroscopic device 200 as a transmissive type. Fig. 4 schematically illustrates an example of the spectroscopic device 200 as a reflective type. As illustrated in Figs. 3 and 4, the spectroscopic device 200 includes the near-infrared light-emitting device 100.

As illustrated in Fig. 3, the spectroscopic device 200 as the transmissive type includes the near-infrared light-emitting device 100 and a spectrometer 6. An inspection object 5 is arranged between the near-infrared light-emitting device 100 and the spectrometer 6. The near-infrared light-emitting device 100 is configured to emit the output light 20. The inspection object 5 is arranged to be irradiated with the output light 20. The spectrometer 6 is arranged to receive transmitted light 11 that has passed through the interior of the inspection object 5, particularly near-infrared transmitted light, out of the output light 20 applied to the inspection object 5. The spectrometer 6 detects and spectrally analyzes the transmitted light 11. The spectrometer 6 is a near-infrared spectrometer, and one provided with a relatively inexpensive Si-based sensor can be used.

The spectroscopic device 200 may be an inspection device. The inspection device may analyze data spectrally analyzed by the spectrometer 6. The inspection device may include an analysis unit not illustrated, and the analysis unit may ascertain or determine pass/fail for inspection items, such as the internal condition and quality, of the inspection object 5. The analysis unit can include a CPU (central processing unit), ROM (read only memory), and RAM (random access memory). The CPU may read programs and reference data stored in the ROM and perform information processing related to analysis of inspection items in accordance with the programs.

As illustrated in Fig. 4, the spectroscopic device 200 as the reflective type also includes the near-infrared light-emitting device 100 and the spectrometer 6. However, in the spectroscopic device 200 of the reflective type, the spectrometer 6 is arranged to receive reflected light 12 reflected from the inspection object 5, particularly near-infrared reflected light, out of the output light 20 applied to the inspection object 5. Other aspects are the same as those of the spectroscopic device 200 of the transmissive type, and thus descriptions thereof are omitted.

The spectroscopic device 200 as the reflective type may include a reflecting member not illustrated, such as a metal plate, particularly a near-infrared reflecting member. By causing the near-infrared light components of the output light 20, which has passed through the inspection object 5, to be reflected by the reflecting member and to pass through the interior of the inspection object 5 again, near-infrared spectroscopic data specific to the inspection object 5 can be easily obtained even if the inspection object 5 is a liquid or the like.

Note that the transmitted light 11 and the reflected light 12 need only include at least near-infrared light components. Depending on the form of the inspection object 5, it can be configured to transmit or reflect visible fluorescence components. In a form that reflects visible light components, the visible light components may be spectrally analyzed, or may be used for external appearance inspection or the like of the inspection object 5.

The inspection object 5 may be a food product. Note that "food product" is a general term for items intended for human consumption, including ingredients of boxed lunches, grains, fruits and vegetables, meat, fish, processed foods, beverages, and the like.

The spectroscopic device 200 can also be used as a foreign substance inspection device for inspecting whether the inspection object 5 includes foreign substances. For example, the spectroscopic device 200 can also be used for detecting the presence or absence and condition of foreign substances mixed into food products. Furthermore, the spectroscopic device 200 can also be used as an inspection device other than a foreign substance inspection device, such as a quality control device for evaluating the quality of fruits and vegetables. By examining the transmission amount of near-infrared light applied to fruits and vegetables, the sugar content, the acidity, the internal damage, or the like of the fruits and vegetables can be evaluated or measured; therefore, the spectroscopic device 200 is suitable for quality control of fruits and vegetables.

In the spectroscopic device 200, at least the near-infrared light components included in the output light 20 is utilized in this manner. The spectroscopic device 200 may detect at least one characteristic absorption band of stretching vibrations selected from the group consisting of N-H, C-H, and O-H. That is, the spectroscopic device 200 may be configured to obtain near-infrared spectroscopic data, such as these characteristic absorption bands. It is preferable to detect characteristic absorption bands as analysis data, as this allows the spectroscopic device 200 to be used in a wide range of applications, providing high versatility.

As described above, the spectroscopic device 200 includes the near-infrared light-emitting device 100, which outputs the output light 20 having near-infrared light components. Therefore, the spectroscopic device 200 according to the present embodiment can be widely used for foreign substance inspection, quality inspection, and the like.

### [Sensing device]

Next, a sensing device according to the present embodiment will be described. In recent years, demand for non-contact vital sensing has been increasing, and the near-infrared light-emitting device according to the present embodiment can be used in a sensing device for non-contact vital sensing.

Non-contact vital sensing is performed by, for example, irradiating a subject with light such as visible light or near-infrared light using a light-emitting device, capturing an image of the subject's imaging area with a camera to obtain image data, and processing the image data with a computer to obtain vital information. Examples of vital information include SpO₂ (oxygen saturation measured using a pulse oximeter), blood pressure, pulse wave, and blood vessel information in the deep tissue of a living body. A device used for non-contact vital sensing, including a light-emitting device, a camera, and a computer is also generally referred to as a sensing device.

The vital information obtained by non-contact vital sensing varies depending on the emission spectrum of output light of the light-emitting device. For example, to obtain blood pressure information, output light having a high intensity of a light component at a wavelength of 850 nm is preferable. To obtain pulse wave information, output light having a high intensity of a light component at a wavelength of 940 nm is preferable. As described above, in non-contact vital sensing, it is preferable to obtain output light having a high intensity of a light component in the near-infrared region.

The near-infrared light-emitting device according to the present embodiment can emit near-infrared light having a fluorescence peak wavelength of 1,000 nm or less with high efficiency, and therefore can be suitably used in the sensing device.

### (Supplementary notes)

The following technologies are disclosed based on the description of the above embodiments.

(Technology 1) A near-infrared phosphor, obtained by doping, with Cr ions, an inorganic compound having the same orthorhombic crystal structure as that of Mg₂GeO₄ and represented by general formula (1)

(MAₚMC_{q})_{z}(MB₂ᵣ)_{1-z}(MD)ₛO₄ ··· (1)

(where MA is one or more elements selected from Group 1 elements and Group 11 elements, MB is one or more elements selected from Group 2 elements and Group 12 elements, MC is one or more elements selected from Group 3 elements and Group 13 elements, MD is one or more elements selected from Group 4 elements and Group 14 elements, and p, q, r, s, and z satisfy 0.8 ≤ p ≤ 1.2, 0.8 ≤ q ≤ 1.2, 0.8 ≤ r ≤ 1.2, 0.8 ≤ s ≤ 1.2, and 0.01 ≤ z ≤ 0.49.).

With this configuration, the fluorescence peak wavelength of fluorescence emitted from the near-infrared phosphor can be set to 1,000 nm or less, enabling detection with high sensitivity even by a Si-based sensor. Since the near-infrared phosphor has excellent fluorescence properties, a high-efficiency near-infrared light-emitting device can be obtained.

(Technology 2) The near-infrared phosphor according to Technology 1, wherein the near-infrared phosphor emits fluorescence when irradiated with excitation light at a wavelength of 450 nm,
a spectral distribution of the fluorescence has a maximum fluorescence intensity value within a wavelength range of 800 nm or more and 1,600 nm or less, and
a full width at half maximum of a spectrum having the maximum fluorescence intensity value exceeds 100 nm.

With this configuration, the near-infrared phosphor can be excited with high efficiency, enabling a high-efficiency near-infrared light-emitting device to be obtained. The near-infrared light-emitting device can be used for moisture content measurement in food, food quality evaluation of fresh fish, meat, and the like, and resin component analysis for the purpose of plastic sorting

(Technology 3) The near-infrared phosphor according to Technology 1 or 2, wherein in general formula (1), MA is an alkali metal element, and MB is an alkaline earth metal element.

With this configuration, it is possible to obtain a near-infrared phosphor that can emit fluorescence detectable with high sensitivity even by a Si-based sensor, and that has excellent fluorescence properties.

(Technology 4) The near-infrared phosphor according to any one of Technologies 1 to 3, wherein general formula (1) satisfies at least one of (1), (2), (3), or (4) below:
(1) MA is Li;
(2) MB is Mg;
(3) MC is Sc, Ga, or Al; or
(4) MD is Ge or Si.

With this configuration, it is possible to obtain a near-infrared phosphor that can emit fluorescence detectable with high sensitivity even by a Si-based sensor, and that has excellent fluorescence properties.

(Technology 5) The near-infrared phosphor according to any one of Technologies 1 to 4, wherein in general formula (1), MA is Li, MB is Mg, MC is Sc, Ga, or Al, and MD is Ge or Si.

With this configuration, it is possible to obtain a near-infrared phosphor that can emit fluorescence detectable with high sensitivity even by a Si-based sensor, and that has excellent fluorescence properties.

(Technology 6) The near-infrared phosphor according to any one of Technologies 1 to 5, wherein the near-infrared phosphor is a powder phosphor or a fluorescent ceramic.

Since the near-infrared phosphor is a powder phosphor, a wavelength converter can be obtained using a simple method of mixing with a transparent resin and curing, thereby enabling easy production of the wavelength converter. Since the near-infrared phosphor is a fluorescent ceramic, a wavelength converter can be obtained that is not only excellent in thermal conductivity but also has a high light absorption rate for excitation light.

(Technology 7) A near-infrared light-emitting device including the near-infrared phosphor according to any one of Technologies 1 to 6.

With this configuration, a near-infrared light-emitting device can be obtained that outputs a high-output near-infrared light component suitable for near-infrared spectroscopy.

(Technology 8) The near-infrared light-emitting device according to Technology 7, further including: a solid-state light-emitting element,
wherein the near-infrared phosphor is excited by excitation light emitted by the solid-state light-emitting element.

With this configuration, a near-infrared light-emitting device can be obtained that outputs a high-output near-infrared light component suitable for near-infrared spectroscopy. By utilizing the solid-state light-emitting element and exciting the near-infrared phosphor with primary light emitted from the solid-state light-emitting element, a near-infrared light-emitting device advantageous for all-solid-state implementation is obtained.

(Technology 9) A spectroscopic device including the near-infrared light-emitting device according to Technology 7 or 8.

This spectroscopic device utilizes a near-infrared light-emitting device that outputs near-infrared light having a wide wavelength range spectral distribution, and is therefore advantageous for application in a wide variety of uses.

(Technology 10) A sensing device including the near-infrared light-emitting device according to Technology 7 or 8.

This sensing device includes a near-infrared light-emitting device that emits near-infrared light having a fluorescence peak wavelength of 1,000 nm or less with high efficiency, and therefore can be suitably used for non-contact vital sensing.

### EXAMPLES

Hereinafter, the present embodiment will be described in further detail by way of examples and comparative examples, but the present embodiment is not limited to these examples.

Note that the following compound powders were used as raw materials when the phosphors of examples are synthesized.
- Lithium carbonate (Li₂CO₃): purity 2N, manufactured by FUJIFILM Wako Pure Chemical Corporation
- Scandium oxide (Sc₂O₃): purity 4N, manufactured by Shin-Etsu Chemical Co., Ltd.
- Magnesium oxide (MgO): purity 3N, manufactured by FUJIFILM Wako Pure Chemical Corporation
- Germanium oxide (GeO₂): purity 3N, manufactured by Kojundo Chemical Lab.
- Chromium oxide (Cr₂O₃): purity 3N, manufactured by Kojundo Chemical Lab.
- Gallium oxide (Ga₂O₃): purity 4N, manufactured by Nippon Rare Metal, Inc.
- Aluminum oxide (Al₂O₃): purity 3N, manufactured by FUJIFILM Wako Pure Chemical Corporation
- Silicon oxide (SiO₂): purity 3N, manufactured by Kojundo Chemical Lab.

### [Preparation of phosphors]

### (Example 1-1)

The oxide phosphor of the present example was synthesized using a solid-state reaction preparation method. Specifically, an oxide phosphor represented by the composition formula (LiSc)_{0.25}(Mg₂)_{0.75}GeO₄:0.3%Cr was synthesized. Note that in the oxide phosphor, the concentration of chromium is the molar amount of chromium relative to the total molar amount of metal elements.

First, the above raw materials were weighed to achieve the stoichiometric composition of (LiSc)_{0.25}(Mg₂)_{0.75}GeO₄:0.3%Cr. Next, dry mixing was performed using a mortar and pestle to obtain a firing raw material.

The above firing raw material was then moved to an alumina crucible having a lid and was fired in an air atmosphere at 1,200 °C for 4 hours using a box-type electric furnace, and the fired product was lightly pulverized. This gave the phosphor of this example. Note that the phosphor composition, the z value when the phosphor is represented by general formula (1), and the firing temperature are summarized in Table 2.

### (Comparative examples 1-2 to 1-5)

Phosphors of respective examples were obtained in the same manner as example 1-1, except that the above raw materials were weighed to achieve the phosphor compositions listed in Table 2. Note that the phosphor of comparative example 1-2 corresponded to the phosphor of Patent Literature 1, the phosphor of comparative example 1-3 corresponded to the phosphor of Non-Patent Literature 1, and comparative example 1-5 corresponded to the phosphor of Non-Patent Literature 2.

### (Examples 2-1 to 2-2 and comparative examples 2-3 to 2-4)

Phosphors of respective examples were obtained in the same manner as example 1-1, except that the above raw materials were weighed to achieve the phosphor compositions listed in Table 2, and the firing temperature was changed to 1,400 °C. Note that the phosphor of example 2-1 was prepared at a higher firing temperature than that used in example 1-1. The phosphor of example 2-2 was prepared at a higher firing temperature and with a lower z value than those used in example 1-1. The phosphor of comparative example 2-3 was prepared at a higher firing temperature than that used in comparative example 1-2. The phosphor of comparative example 2-4 was prepared at a higher firing temperature than that used in comparative example 1-3.

### (Example 3-1 and comparative examples 3-2 to 3-3)

Phosphors of respective examples were obtained in the same manner as example 1-1, except that the above raw materials were weighed to achieve the phosphor compositions listed in Table 3. Note that the phosphor of example 3-1 was prepared by replacing scandium (Sc) in the phosphor of example 1-1 with gallium (Ga) and further increasing the amount of chromium added. The phosphor of comparative example 3-2 was prepared by replacing scandium (Sc) in the phosphor of comparative example 1-2 with gallium (Ga) and further increasing the amount of chromium added. The phosphor of comparative example 3-3 was prepared by increasing the amount of chromium added than that of comparative example 1-3, and corresponded to the phosphor of Non-Patent Literature 1.

### (Example 4-1 and comparative examples 4-2 and 4-3)

Phosphors of respective examples were obtained in the same manner as example 1-1, except that the above raw materials were weighed to achieve the phosphor compositions listed in Table 3. Note that the phosphor of example 4-1 was prepared by replacing scandium (Sc) in the phosphor of example 1-1 with aluminum (Al) and further increasing the amount of chromium added. The phosphor of comparative example 4-2 was prepared by replacing scandium (Sc) in the phosphor of comparative example 1-2 with aluminum (Al) and further increasing the amount of chromium added. The phosphor of comparative example 4-3 was the same as that of comparative example 3-3.

### (Example 5-1 and comparative examples 5-2 and 5-3)

Phosphors of respective examples were obtained in the same manner as example 1-1, except that the above raw materials were weighed to achieve the phosphor compositions listed in Table 3. Note that the phosphor of example 5-1 was prepared by replacing germanium (Ge) in the phosphor of example 1-1 with silicon (Si) and further increasing the amount of chromium added. The phosphor of comparative example 5-2 was prepared by replacing germanium (Ge) in the phosphor of comparative example 1-2 with silicon (Si) and further increasing the amount of chromium added. The phosphor of comparative example 5-3 was prepared by replacing germanium (Ge) in the phosphor of comparative example 1-3 with silicon (Si) and further increasing the amount of chromium added.

**[Table 1]**

| | Phosphor composition | z | Firing temperature (°C) | IQE (%) | Abs. (%) | Fluorescence peak wavelength (nm) | FWHM (nm) | Remarks |
|---|---|---|---|---|---|---|---|---|
| Example 1-1 | (LiSc)_{0.25}(Mg₂)_{0.75}GeO₄:0.3%Cr | 0.25 | 1200 | 20 | 41 | 960 | 260 | Standard example |
| Comparative example 1-2 | (LiSc)_{0.5}(Mg₂)_{0.5}GeO₄:0.3%Cr | 0.5 | 1200 | 14 | 39 | 1000 | 270 | Patent Literature 1 |
| Comparative example 1-3 | Mg₂GeO₄:0.3%Cr | 0 | 1200 | 6 | 24 | 900 | 350 | Non-Patent Literature 1 |
| Comparative example 1-4 | (LiSc)_{0.75}(Mg₂)_{0.25}GeO₄:0.3%Cr | 0.75 | 1200 | 11 | 39 | 1050 | 250 | Higher z |
| Comparative example 1-5 | LiScGeO₄:0.3%Cr | 1 | 1200 | 17 | 36 | 1100 | 300 | Non-Patent Literature 2 |
| Example 2-1 | (LiSc)_{0.25}(Mg₂)_{0.75}GeO₄:0.3%Cr | 0.25 | 1400 | 23 | 41 | 940 | 200 | High temperature firing |
| Example 2-2 | (LiSc)_{0.1}(Mg₂)_{0.9}GeO₄:0.3%Cr | 0.1 | 1400 | 9 | 29 | 920 | 300 | High temperature firing, lower z |
| Comparative example 2-3 | (LiSc)_{0.5}(Mg₂)_{0.5}GeO₄:0.3%Cr | 0.5 | 1400 | 8 | 38 | 1000 | 230 | Patent Literature 1, high temperature firing |
| Comparative example 2-4 | Mg₂GeO₄:0.3%Cr | 0 | 1400 | 3 | 33 | - | - | Non-Patent Literature 1, high temperature firing |

| | | | | | | | | |
|---|---|---|---|---|---|---|---|---|
| The chromium concentration in the table represents "the molar amount of chromium relative to the molar amount of metal elements". | | | | | | | | |

| | Phosphor composition | z | Firing temperature (°C) | IQE (%) | Abs. (%) | Fluorescence peak wavelength (nm) | FWHM (nm) | Remarks |
|---|---|---|---|---|---|---|---|---|
| Example 3-1 | (LiGa)_{0.25}(Mg₂)_{0.75}GeO₄:1.3%Cr | 0.25 | 1200 | 19 | 36 | 860 | 200 | Sc→Ga |
| Comparative example 3-2 | (LiGa)_{0.5}(Mg₂)_{0.5}GeO₄:1.3%Cr | 0.5 | 1200 | 12 | 32 | 870 | 180 | Sc→Ga |
| Comparative example 3-3 | Mg₂GeO₄:1.3%Cr | 0 | 1200 | 1 | 41 | - | - | Non-Patent Literature 1 |
| Example 4-1 | (LiAl)_{0.25}(Mg₂)_{0.75}GeO₄:1.3%Cr | 0.25 | 1200 | 14 | 49 | 930 | 230 | Sc→Al |
| Comparative example 4-2 | (LiAl)_{0.3}(Mg₂)_{0.5}GeO₄:1.3%Cr | 0.5 | 1200 | 10 | 49 | 850 | 170 | Sc→Al |
| Comparative example 4-3 (Comparative example 3-3) | Mg₂GeO₄:1.3%Cr | 0 | 1200 | 1 | 41 | - | - | Non-Patent Literature 1 |
| Example 5-1 | (LiSc)_{0.25}(Mg₂)_{0.75}SiO₄:1.3%Cr | 0.25 | 1200 | 15 | 50 | 940 | 200 | Ge→Si |
| Comparative example 5-2 | (LiSc)_{0.3}(Mg₂)_{0.5}SiO₄:1.3%Cr | 0.5 | 1200 | 8 | 46 | 960 | 250 | Ge→Si |
| Comparative example 5-3 | Mg₂SiO₄:1.3%Cr | 0 | 1200 | 9 | 34 | 810 | 200 | Ge→Si |

| | | | | | | | | |
|---|---|---|---|---|---|---|---|---|
| The chromium concentration in the table represents "the molar amount of chromium relative to the molar amount of metal elements". | | | | | | | | |

### [Evaluation]

Next, the crystal structure and fluorescence properties of the compounds configuring the phosphors were evaluated in the synthesized phosphor samples.

### (Crystal structure analysis)

X-ray diffraction patterns of the phosphors of example 1-1 and comparative examples 1-2 to 1-5 were measured using the X-ray diffraction method with a desktop X-ray diffractometer MiniFlex600 (Rigaku Corporation). The crystal phases of the compounds configuring the phosphors were then identified through comparison with diffraction patterns of registered compound crystals.

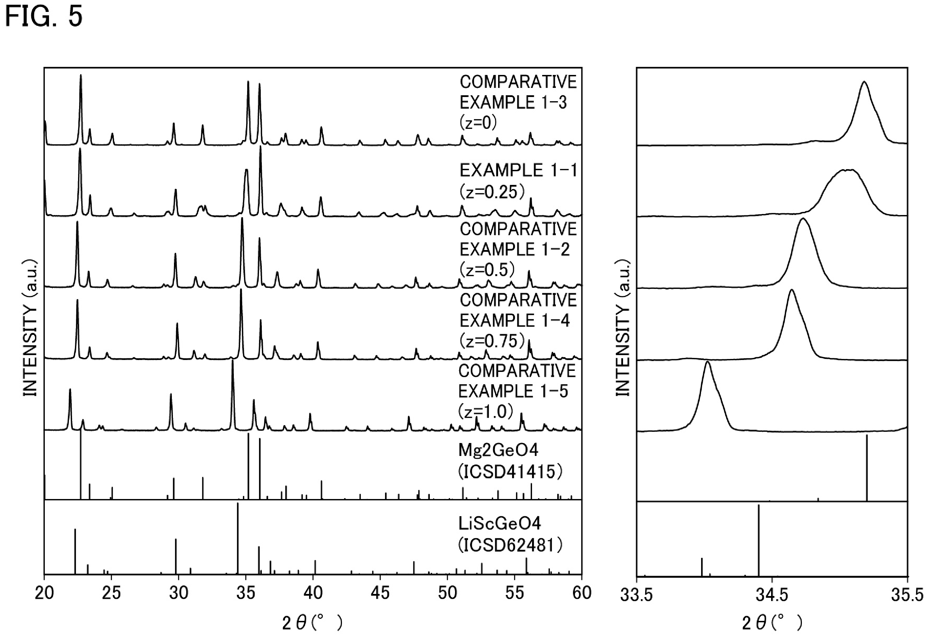

As illustrated in FIG. 5, it can be seen that the phosphors of example 1-1 and comparative examples 1-2 to 1-5 exhibit diffraction patterns similar to that of Mg₂GeO₄. Therefore, it can be seen that these phosphors have the same crystal structure as Mg₂GeO₄. From FIG. 5, it can be seen that the diffraction lines shift to the lower angle side as the z value increases. Therefore, in the phosphors of example 1-1, comparative example 1-2, and comparative example 1-4, it is presumed that Mg₂GeO₄ and LiScGeO₄ form a complete solid solution.

Therefore, the phosphor of example 1-1 can be seen to have the same orthorhombic crystal structure as compound Mg₂GeO₄, and to be a Cr-activated phosphor having a solid solution of Mg₂GeO₄ and LiScGeO₄ as the host crystal. The phosphor of example 1-1 can also be seen to be a Cr-activated phosphor having an intermediate composition between Mg₂GeO₄ and LiScMg₂Ge₂O₈ as the host crystal.

### (Fluorescence Properties)

The fluorescence properties of the phosphors when excited at an excitation wavelength of 450 nm were measured using Quantaurus-QY Plus (extended type, absolute PL quantum yield measurement device with heating mechanism) C13534-02 (manufactured by Hamamatsu Photonics K.K.). The fluorescence properties measured were internal quantum efficiency (IQE), light absorption rate (Abs.), fluorescence spectrum, wavelength of maximum fluorescence intensity value (fluorescence peak wavelength), and full width at half maximum (FWHM) of the spectrum having the maximum fluorescence intensity value, all in the wavelength range of 600 nm to 1,600 nm. The measurement results for the fluorescence properties are summarized in Tables 2 and 3.

As listed in Table 2, the phosphor of example 1-1 has a fluorescence peak wavelength of 960 nm, which can be seen to be 1,000 nm or less for detection with high sensitivity using a Si-based sensor. The phosphor of example 1-1 can be seen to have improved internal quantum efficiency and light absorption rate compared to the phosphors of comparative examples 1-2 to 1-5. The phosphor of example 1-1 can be seen to have a full width at half maximum exceeding 250 nm.

From examples 1-1 and 2-1, it can be seen that by increasing the amount of Cr added and the firing temperature at the time of preparing the phosphor, the fluorescence peak wavelength can be further shifted to shorter wavelengths while the internal quantum efficiency is enhanced. From example 2-2 and comparative examples 2-3 and 2-4, it can be seen that when the z value is changed to 0.1, the fluorescence peak wavelength can be further shifted to shorter wavelengths while decrease in internal quantum efficiency is controlled.

From example 3-1 and comparative examples 3-2 and 3-3 listed in Table 3, it can be seen that even when scandium in the phosphor of example 1-1 is replaced with gallium, the internal quantum efficiency is favorable, and the fluorescence peak wavelength can be shifted to shorter wavelengths below 900 nm.

From example 4-1 and comparative examples 4-2 and 4-3, it can be seen that even when scandium in the phosphor of example 1-1 is replaced with aluminum, the internal quantum efficiency and light absorption rate are favorable, and the fluorescence peak wavelength can be shifted to shorter wavelengths below 950 nm.

From example 5-1 and comparative examples 5-2 and 5-3, it can be seen that even when germanium in the phosphor of example 1-1 is replaced with silicon, the internal quantum efficiency and light absorption rate are favorable, and the fluorescence peak wavelength can be shifted to shorter wavelengths below 950 nm.

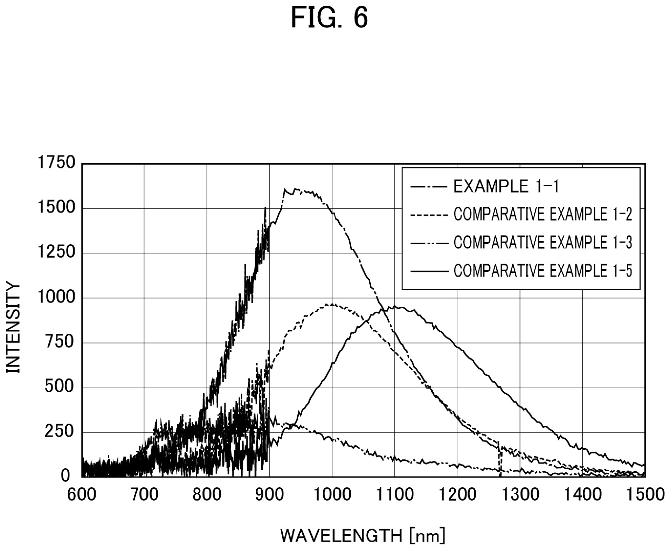

Table 4 summarizes the composition, z value, internal quantum efficiency (IQE), light absorption rate (Abs.), external quantum efficiency (EQE), and fluorescence peak wavelength of the phosphors of example 1-1 and comparative examples 1-2, 1-3, and 1-5. Note that the external quantum efficiency was measured through excitation at a wavelength of 450 nm using Quantaurus-QY Plus (extended type, absolute PL quantum yield measurement device with heating mechanism) C13534-02 (manufactured by Hamamatsu Photonics K.K.). FIG. 6 illustrates the emission spectra when the phosphors of example 1-1 and comparative examples 1-2, 1-3, and 1-5 are excited at a wavelength of 450 nm.

As described above, the phosphor of example 1-1 is a Cr-activated phosphor having the same orthorhombic crystal structure as compound Mg₂GeO₄ and having an intermediate composition between Mg₂GeO₄ and LiScMg₂Ge₂O₈ as the host crystal. However, it can be seen that the internal quantum efficiency, light absorption rate, and external quantum efficiency of the phosphor of example 1-1 are improved compared to the phosphors of comparative examples 1-2, 1-3, and 1-5. That is, the fluorescence properties of the phosphor of example 1-1 are not merely at an intermediate value between the fluorescence properties of the phosphors of comparative examples 1-2 and 1-3, but are surprisingly improved beyond the fluorescence properties of those phosphors. Furthermore, since the fluorescence peak wavelength of the phosphor of example 1-1 is 1,000 nm or less, detection with high sensitivity is possible even by a relatively inexpensive Si-based sensor.

**[Table 4]**

| | Comparative example 1-3 (Non-Patent Literature 1) | Example 1-1 | Comparative example 1-2 (Patent Literature 1) | Comparative example 1-5 (Non-Patent Literature 2) |
|---|---|---|---|---|
| Composition | Mg₂GeO₄ :0.3%Cr | (LiSc)_{0.25}(Mg₂)_{0.75}GeO₄ :0.3%Cr | LiMg₂ScGe₂O₈ :0.3%Cr | LiScGeO₄ :0.3%Cr |
| z | 0 | 0.25 | 0.5 | 1 |
| Internal quantum efficiency (IQE) | 6% | 20% | 14% | 17% |
| Light absorption rate (Abs.) | 24% | 41% | 39% | 36% |
| External quantum efficiency (EQE) | 1.40% | 8.20% | 5.50% | 6.10% |
| Fluorescence peak wavelength | 900nm | 960nm | 1000nm | 1100nm |

Although the present embodiment has been described above, the present embodiment is not limited to these descriptions, and various modifications are possible within the scope of the gist according to the present embodiment.

The entire contents of Japanese Patent Application No. 2024-007866 (filed on: January 23, 2024) are incorporated herein by reference.

### INDUSTRIAL APPLICABILITY

In the present disclosure, it is possible to provide a near-infrared phosphor that can emit fluorescence detectable with high sensitivity even by a Si-based sensor, and that has excellent fluorescence properties, as well as a near-infrared light-emitting device including the near-infrared phosphor. According to the present disclosure, it is further possible to provide a spectroscopic device and a sensing device each including the near-infrared light-emitting device.

### REFERENCE SIGNS LIST

- 1: Solid-state light-emitting element
- 100: Near-infrared light-emitting device
- 200: Spectroscopic device

## Claims

1. A near-infrared phosphor, obtained by doping, with Cr ions, an inorganic compound having the same orthorhombic crystal structure as that of Mg₂GeO₄ and represented by general formula (1)
(MAₚMC_{q})_{z}(MB₂ᵣ)_{1-z}(MD)ₛO₄ ··· (1)
(where MA is one or more elements selected from Group 1 elements and Group 11 elements, MB is one or more elements selected from Group 2 elements and Group 12 elements, MC is one or more elements selected from Group 3 elements and Group 13 elements, MD is one or more elements selected from Group 4 elements and Group 14 elements, and p, q, r, s, and z satisfy 0.8 ≤ p ≤ 1.2, 0.8 ≤ q ≤ 1.2, 0.8 ≤ r ≤ 1.2, 0.8 ≤ s ≤ 1.2, and 0.01 ≤ z ≤ 0.49.).

2. The near-infrared phosphor according to claim 1, wherein the near-infrared phosphor emits fluorescence when irradiated with excitation light at a wavelength of 450 nm,
a spectral distribution of the fluorescence has a maximum fluorescence intensity value within a wavelength range of 800 nm or more and 1,600 nm or less, and
a full width at half maximum of a spectrum having the maximum fluorescence intensity value exceeds 100 nm.

3. The near-infrared phosphor according to claim 1 or 2, wherein in general formula (1), MA is an alkali metal element and MB is an alkaline earth metal element.

4. The near-infrared phosphor according to any one of claims 1 to 3, wherein general formula (1) satisfies at least one of (1), (2), (3), or (4) below:
(1) MA is Li;
(2) MB is Mg;
(3) MC is Sc, Ga, or Al; or
(4) MD is Ge or Si.

5. The near-infrared phosphor according to any one of claims 1 to 4, wherein in general formula (1), MA is Li, MB is Mg, MC is Sc, Ga, or Al, and MD is Ge or Si.

6. The near-infrared phosphor according to any one of claims 1 to 5, wherein the near-infrared phosphor is a powder phosphor or a fluorescent ceramic.

7. A near-infrared light-emitting device comprising: the near-infrared phosphor according to any one of claims 1 to 6.

8. The near-infrared light-emitting device according to claim 7, further comprising: a solid-state light-emitting element,
wherein the near-infrared phosphor is excited by excitation light emitted by the solid-state light-emitting element.

9. A spectroscopic device comprising the near-infrared light-emitting device according to claim 7 or 8.

10. A sensing device comprising the near-infrared light-emitting device according to claim 7 or 8.
